Europäisches Patentamt

European Patent Office

Office européen des brevets

(11) Numéro de publication: **0 230 617**
**A1**

## (12) DEMANDE DE BREVET EUROPEEN

(21) Numéro de dépôt: 86117625.3

(51) Int. Cl.⁴: **C30B 15/02**

(22) Date de dépôt: **18.12.86**

(30) Priorité: **23.12.85 FR 8519041**

(43) Date de publication de la demande:
**05.08.87 Bulletin 87/32**

(84) Etats contractants désignés:
**AT BE CH DE ES FR GB GR IT LI LU NL SE**

(71) Demandeur: **COMPAGNIE GENERALE D'ELECTRICITE Société anonyme dite:**
**54, rue La Boétie**
**F-75382 Paris Cedex 08(FR)**
Demandeur: **SOCIETE NATIONALE ELF AQUITAINE Société anonyme dite**
**Tour Elf 2, Place de la Coupole La Défense 6**
**F-92400 Courbevoie(FR)**

(72) Inventeur: **Belouet, Christian**
**1, rue Gaston Levy**
**F-92330 Sceaux(FR)**
Inventeur: **Mautref, Michel**
**19 rue des Myosotis**
**F-77330 Ozoir La Ferriere(FR)**

(74) Mandataire: **Weinmiller, Jürgen et al**
**Lennéstrasse 9 Postfach 24**
**D-8133 Feldafing(DE)**

(54) **Dispositif pour former un bain d'un matériau semi-conducteur fond afin d'y faire croître un élément cristallin.**

(57) Il comporte un récipient d'alimentation (10) dont le fond est muni d'une ouverture (14), des moyens d'alimentation (15 à 17) du récipient (10) en silicium solide et des moyens de chauffage (11 à 13) du récipient, celui-ci étant placé au dessus d'un creuset (1) contenant le bain (8) pour que le silicium liquide du récipient (10) s'écoule par l'ouverture (14) dans le creuset (1) lorsque le niveau (h) de silicium liquide dans le récipient atteint une valeur maximale (20), cet écoulement s'arrêtant lorsque le niveau (h) est descendu à une valeur minimale (22).

Application au dépôt d'une couche de silicium polycristallin sur un ruban de carbone.

## Dispositif pour former un bain d'un matériau semi-conducteur fondu afin d'y faire croître un élément cristallin

La présente invention a pour objet un dispositif pour former un bain d'un matériau semi-conducteur afin d'y faire croître un élément cristallin.

Ce dispositif est d'un type comportant :
- un creuset
- des moyens pour apporter du matériau semi-conducteur dans le creuset,
- des moyens de chauffage du creuset,
- et des moyens pour faire croître l'élément cristallin dans le bain.

Un dispositif connu de ce type est décrit dans l'article "Growth of polysilicon sheets on a carbon shaper by the RAD process" (C. Belouet et al) extrait de "Journal of crystal growth" 61 (1983), pages 615 à 628, North-Holland Publishing Company. Dans ce dispositif, le matériau semi-conducteur est le silicium et l'élément cristallin qui croît dans le bain est une couche de silicium polycristallin déposée sur un ruban de carbone ; les moyens pour apporter du matériau semi-conducteur dans le creuset comportent un distributeur électromécanique capable de déposer dans le creuset, à intervalles de temps réguliers, des petits cubes de silicium préchauffés à 1000° C.

Ce dispositif comporte des inconvénients. En effet lorsque les cubes de silicium arrivent dans le bain, celui-ci se refroidit, ce qui a une répercussion immédiate sur l'épaisseur de la couche déposée sur le ruban. D'autre part la durée de fusion des cubes de silicium dans le bain est parfois trop lente pour compenser les pertes de silicium liquide du bain provoquées par la croissance de l'élément cristallin.

La présente invention a pour but de pallier ces inconvénients.

Elle a pour objet un dispositif pour former un bain d'un matériau semi-conducteur fondu afin d'y faire croître un élément cristallin, du type mentionné ci-dessus, caractérisé en ce que lesdits moyens pour apporter du matériau semi-conducteur dans le creuset comprennent
- un récipient dont le fond est muni d'une ouverture, ce récipient étant disposé au-dessus du creuset de manière que l'ouverture soit à la verticale de l'intérieur du creuset,
- des moyens d'alimentation du récipient pour déposer dans ce récipient des granulés dudit matériau semi-conducteur
- et des moyens de chauffage du récipient, capables de provoquer la fusion des granulés pour former dans le récipient un liquide semi-conducteur fondu, la section de l'ouverture du récipient étant choisie de manière que ledit liquide fondu reste à l'intérieur du récipient tant que le niveau de ce liquide n'atteint pas une valeur maximale, le liquide s'écoulant par ladite ouverture dans le creuset pour constituer ledit bain dès que le niveau du liquide atteint cette valeur maximale, l'écoulement du liquide se poursuivant tant que son niveau dans le récipient est supérieur à une valeur minimale inférieure à ladite valeur maximale, les moyens de chauffage du creuset étant capables de maintenir en fusion le bain à partir duquel croît ledit élément cristallin.

Le dispositif selon l'invention peut comporter en outre :
- un premier détecteur de niveau, apte à émettre un premier signal électrique lorsque le niveau du bain dans le creuset est inférieur à une valeur prédéterminée,
- un deuxième détecteur de niveau, apte à émettre un deuxième signal électrique lorsque le niveau du liquide semi-conducteur fondu dans le récipient est supérieur à un seuil prédéterminé, ce seuil étant inférieur à la dite valeur maximale et supérieur à ladite valeur minimale,
- un circuit de commande, relié au deuxième détecteur et aux moyens d'alimentation du récipient, ce circuit étant capable de commander le fonctionnement desdits moyens d'alimentation lorsque le deuxième signal n'est pas émis, ce circuit étant bloqué lorsqu'il reçoit le deuxième signal
- et un circuit de déblocage, relié au premier détecteur et au circuit de commande, le circuit de déblocage étant capable d'émettre un troisième signal électrique lorsque le premier signal est émis, ce troisième signal étant capable de débloquer le circuit de commande lorsqu'il est bloqué par le deuxième signal, ce troisième signal n'ayant aucun effet sur le circuit de commande lorsqu'il n'est pas bloqué par le deuxième signal.

Selon un mode de réalisation du dispositif selon l'invention, le matériau semi-conducteur est du silicium et ledit élément cristallin est une couche de silicium déposée sur un support de carbone.

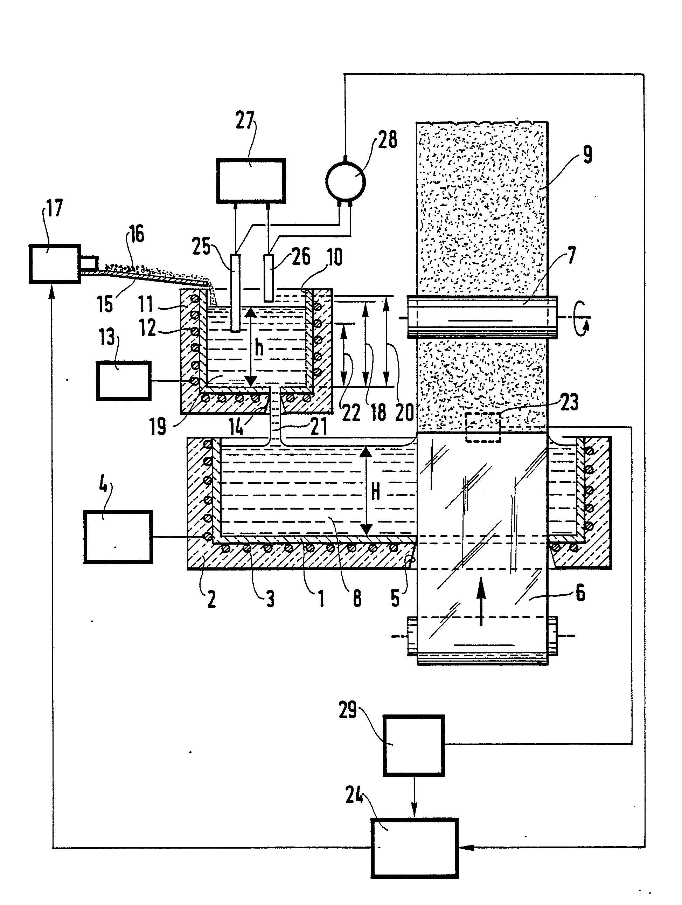

Des formes particulières d'exécution de l'objet de la présente invention sont décrites ci-dessous, à titre d'exemple, en référence au dessin annexé dans lequel la figure unique représente un mode de réalisation du dispositif selon l'invention.

Sur cette figure, est représenté un creuset 1 en quartz dont la surface extérieure est entourée par un four électrique 2 muni d'une résistance 3 de chauffage reliée à une source d'énergie électrique 4. Le fond de la cuve constituée par le creuset 1 et le four 2 comporte une fente 5 à travers laquelle passe verticalement un ruban de carbone 6 tiré vers le haut par des moyens mécaniques pouvant comporter par exemple des rouleaux 7. Un bain de silicium fondu 8 est contenu dans le creuset 1, les dimensions de la fente étant déterminées pour éviter toute fuite de silicium fondu. Le ruban 6 traverse le bain 8 de façon que ses deux faces planes soient revêtues à la sortie du bain par une couche 9 de silicium solide polycristallin.

Au-dessus du creuset 1 est disposé un récipient 10, également en quartz, dont la surface extérieure est entourée par un four électrique 11 muni d'une résistance de chauffage 12 reliée à une source d'énergie électrique 13. Le fond de la cuve constituée par le récipient 10 et le four 11 comporte une ouverture 14. Sur le bord supérieur du récipient 10 est disposée une goulotte 15 inclinée vers l'intérieur du récipient 10. Dans la goulotte sont placés des granulés 16 de silicium. Sur la goulotte est fixée la sortie mécanique d'un transducteur électro-mécanique 17.

Le dispositif décrit ci-dessus et illustré par les éléments 1 à 17 de la figure fonctionne de la manière suivante.

On met en marche le transducteur électro-mécanique qui délivre des vibrations ultrasonores de façon à entraîner le glissement des granulés 16 sur la goulotte inclinée 15 vers l'intérieur du récipient 10. La chaleur dégagée par le four 10 permet de fondre les granulés 16 pour former un volume liquide 19 de silicium fondu contenu dans le récipient 10. La section de l'ouverture 14 est choisie de manière que le volume liquide 19 reste dans le récipient 10 sans s'écouler par l'ouverture 14 tant que le niveau h de silicium fondu dans le récipient 10 est inférieur à une valeur maximale 20. Dès que le niveau de silicium fondu dans le récipient 10 atteint la valeur maximale 20, le générateur 17 est stoppé ; le silicium liquide contenu dans le récipient 10 s'écoule alors par l'ouverture 14 dans le creuset 1 suivant une colonne cylindrique liquide 21, jusqu'à ce que le niveau de silicium liquide dans le récipient soit descendu à une valeur minimale 22 inférieure à la valeur maximale 20. De préférence l'axe de la colonne 21 est situé sensiblement dans le plan du ruban.

On remet en marche le transducteur 17 et on provoque ainsi plusieurs écoulements successifs de silicium liquide jusqu'à ce que le niveau du bain 8 ait atteint une valeur prédéterminée Ho, le silicium liquide du bain étant maintenu à la température de fusion grâce à l'énergie calorifique apportée par le four 2.

Le dépôt de la couche 9 de silicium polycristallin sur le ruban 6 provoque le prélèvement d'une quantité correspondante de silicium fondu du bain 8, ce qui entraîne une baisse de son niveau.

Pour compenser cette baisse de niveau, on met en marche le transducteur 17 lorsque le niveau du bain 8 descend en dessous de la valeur prédéterminée Ho. Dès que le niveau du liquide fondu dans le récipient 10 atteint la valeur 20, un volume de silicium fondu égal au produit de la section du récipient 10 par la différence entre les niveaux 20 et 22 s'écoule du récipient 10 dans le creuset 1.

A titre indicatif, pour un récipient cylindrique de diamètre intérieur 28 mm, muni d'une ouverture inférieure cylindrique de diamè tre 3 mm, les valeurs de niveau 20 et 22 sont respectivement de 27,5 et de 21 mm. Chaque coulée de silicium fondu a donc un volume d'environ 4 cm3. Si on admet que le tirage provoque une consommation de silicium liquide de 0,67 cm3/mn, une coulée suffit à compenser la consommation de silicium du dispositif pendant 5 mn 30 s.

Le dispositif décrit ci-dessus permet en alimentant le bain 8 en silicium liquide, d'éviter le déséquilibre thermique qui se produit dans l'art antérieur lorsque le silicium solide arrive dans le bain. Il présente en outre l'avantage de ne comporter aucune connexion physique et aucune partie mobile (tel qu'un piston par exemple) entre le récipient d'alimentation et le creuset. Il est de réalisation simple ; le volume interne du récipient peut-être très réduit de façon à nécessiter une faible consommation d'énergie thermique.

On complète de préférence le dispositif qui vient d'être décrit par un système de régulation automatique du niveau du bain 8.

Sur la figure, ce système comporte un détecteur photoélectrique 23 du niveau H du bain 8 dans le creuset 1, ce détecteur pouvant être du type de celui décrit dans la demande de brevet français publié sous le numéro 2.551.233. La sortie électrique du détecteur 23 est reliée à l'entrée d'un circuit de déblocage 29.

Un détecteur de niveau du silicium liquide dans le récipient 10 comporte une électrode en graphite 25 disposée verticalement à l'intérieur du récipient 10 de manière que son extrémité inférieure soit légèrement au-dessous du niveau 22. Une autre électrode en graphite 26 est disposée verticalement à l'intérieur du récipient 10 de manière que son extrémité inférieure soit à un niveau 18 légèrement au-dessous du niveau 20. Les électrodes 25 et 26 sont connectées respectivement aux deux bornes d'un générateur 27 de courant électrique. Les deux électrodes 25 et 26 sont également connectées à l'entrée d'un circuit 28 dont la sortie est reliée au transducteur 17 par l'intermédiaire d'un circuit 24 de commande. La sortie du circuit 29 est connectée au circuit 24.

Lorsque l'électrode 26 n'est pas immergée dans le liquide 19 contenu dans le récipient 10, le générateur 17 délivre sa tension à vide à l'entrée du circuit 28. Celui-ci ne délivre alors à sa sortie aucun signal électrique. Lorsque le niveau du liquide 19 atteint la valeur 18, l'extrémité inférieure de l'électrode 26 est immergée et le générateur 27 délivre un courant électrique qui s'écoule dans le silicium liquide à travers les électrodes 25 et 26. Le générateur 27 a une basse impédance, de sorte que sa tension en charge est nettement plus basse que sa tension à vide. Lorsque le circuit 28 reçoit sur son entrée la tension en charge du générateur 27, il délivre un signal électrique.

Par ailleurs le détecteur 23 de niveau du bain 8 du creuset 1 délivre un signal électrique lorsque le niveau H du bain 8 est infé rieur au niveau Ho, et ne délivre aucun signal lorsque le niveau H est égal ou supérieur à Ho.

Le système de régulation automatique de niveau du bain 8 fonctionne de la manière suivante,

Le circuit de commande 24 commande le fonctionnement du transducteur 17 tant que le niveau h dans le récipient 10 reste inférieur à la valeur 18. Le liquide 19 est approvisionné en solicium solide et son niveau h monte. Lorsque ce niveau atteint la valeur seuil 18, le circuit 24 reçoit sur son entrée le signal électrique délivré par le circuit 28, ce qui entraîne le blocage du circuit 24. Deux cas peuvent alors se présenter.

Si le niveau H du bain 8 dans le creuset 1 est inférieur à la valeur Ho, le détecteur 23 délivre un signal électrique qui est reçu par le circuit de déblocage 29. Celui-ci délivre alors un signal électrique vers le circuit de commande 24 qui se trouve débloqué. Le transducteur 17 fonctionne et continue d'alimenter en silicium solide le liquide 19 dont le niveau h monte justqu'à la valeur 20. Le liquide 19 s'écoule alors par l'ouverture 14 dans le bain 8. Dès que le niveau h du liquide 19 est descendu en dessous de la valeur 18, le circuit de commande 24 qui ne reçoit plus le signal électrique provenant du circuit 28 n'est plus bloqué par ce signal et commande de nouveau normalement le fonctionnement du transducteur 17. Bien entendu, le signal de déblocage que le circuit 24 continue de recevoir n'a aucun effet sur ce circuit. Le récipient 10 perd plus de liquide par l'ouverture 14 qu'il n'en gagne par son approvisionnement en silicium solide. Lorsque le niveau du liquide 19 est descendu à la valeur 22, le liquide cesse de s'écouler par l'ouverture 14 et son niveau remonte de nouveau.

Si par contre le niveau H du bain 8 dans le creuset 1 est égal ou supérieur à Ho, le détecteur 23 ne délivre aucun signal électrique. Le circuit 24 reste bloqué et le récipient 10 n'est plus approvisionné en silicium solide. Le récipient 10 reste donc rempli au niveau 18 jusqu'à ce que le niveau H du bain 8 descende en dessous du niveau Ho.

Donc le niveau du bain 8 est maintenu à la valeur Ho, avec une précision qui dépend du volume de silicium liquide compris dans le réci pient 10 entre les niveau 20 et 22.

Bien entendu, le dispositif selon la présente invention peut s'appliquer à la formation d'un bain quelconque d'un matériau semi-conducteur fondu, en vue par exmple du tirage du monocristaux. De plus, le niveau de silicium liquide dans le récipient peut être détecté par d'autres moyens que ceux décrits, par exemple par détection photoélectrique d'un faisceau laser réfléchi par la surface d'équilibre du silicium liquide.

## Revendications

1/ Dispositif pour former un bain d'un matériau semi-conducteur fondu, afin d'y faire croître un élément cristallin, comportant
-un creuset,
-des moyens pour apporter du matériau semi-conducteur dans le creuset,
-des moyens de chauffage du creuset,
-et des moyens pour faire croître l'élément cristallin dans le bain, caractérisé en ce que lesdits moyens pour apporter du matériau semi-conducteur dans le creuset comprennent
-un récipient (10) dont le fond est muni d'une ouverture (14), ce récipient (10) étant disposé au-dessus du creuset (1) de manière que l'ouverture - (14) soit à la verticale de l'intérieur du creuset (1),
-des moyens d'alimentation (15 à 17) du récipient - (10) pour déposer dans ce récipient (10) des granulés (16) dudit matériau semi-conducteur
-et des moyens (11 à 13) de chauffage du récipient (10), capables de provoquer la fusion des granulés (16) pour former dans le récipient un liquide semi-conducteur fondu (19), la section de l'ouverture - (14) du récipient (10) étant choisie de manière que ledit liquide fondu reste à l'intérieur du récipient - (10) tant que le niveau (h) de ce liquide n'atteint pas une valeur maximale (20), le liquide s'écoulant par ladite ouverture (14) dans le creuset (1) pour constituer ledit bain (8) dès que le niveau (h) du liquide atteint cette valeur maximale (20), l'écoulement du liquide se poursuivant tant que son niveau (h) est supérieur à une valeur minimale - (22) inférieure à ladite valeur maximale (20), les moyens de chauffage (4) du creuset (1) étant capables de maintenir en fusion le bain (8) à partir duquel croît ledit élément cristallin (9).

2/ Dispositif selon la revendication 1, caractérisé en ce qu'il comporte en outre
-un premier détecteur (23) de niveau, apte à émettre un premier signal électrique lorsque le niveau (H) du bain (8) dans le creuset (1) est inférieur à une valeur prédéterminée,
-un deuxième détecteur (28) de niveau, apte à émettre un deuxième signal électrique lorsque le niveau (h) du liquide semi-conducteur fondu (19) dans le récipient (10) est supérieur à un seuil prédéterminé (18), ce seuil (18) étant inférieur à la dite valeur maximale (20) et supérieur à ladite valeur minimale (22),
-un circuit (24) de commande, relié au deuxième détecteur (28) et aux moyens (17) d'alimentation du récipient (10), ce circuit (24) étant capable de commander le fonctionnement desdits moyens - (17) d'alimentation lorsque le deuxième signal n'est pas émis, ce circuit (24) étant bloqué lorsqu'il reçoit le deuxième signal
-et un circuit (29) de déblocage, relié au premier détecteur (23) et au circuit (24) de commande, le circuit (29) de déblocage étant capable d'émettre un troisième signal électrique lorsque le premier signal est émis, ce troisième signal étant capable de débloquer le circuit (24) de commande lorsqu'il est bloqué par le deuxième signal, ce troisième signal n'ayant aucun effet sur le circuit (24) de commande lorsqu'il n'est pas bloqué par le deuxième signal.

3/ Dispositif selon l'une quelconque des revendications 1 et 2, caractérisé en ce que ledit matériau semi-conducteur est du silicium et ledit élément cristallin est une couche (9) de silicium déposée sur un support (6) de carbone.

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl.4) |
|---|---|---|---|
| A | US-A-3 002 821 (C. HARON) | | C 30 B 15/02 |
| A | FR-A-1 302 043 (UNION CARBIDE) | | |
| A | GB-A- 784 617 (SIEMENS) | | |

| | | | DOMAINES TECHNIQUES RECHERCHES (Int. Cl.4) |
|---|---|---|---|
| | | | C 30 B 15/02 |

Le présent rapport de recherche a été établi pour toutes les revendications

| Lieu de la recherche | Date d'achèvement de la recherche | Examinateur |
|---|---|---|
| LA HAYE | 24-04-1987 | BRACKE P.P.J.L. |